# EUROPEAN PATENT SPECIFICATION

(11) **EP 4 109 506 B1**
(45) Date of publication and mention of the grant of the patent: **17.06.2026**
(21) Application number: 22169630.5
(22) Date of filing: 25.04.2022
(51) Int. Cl.: H10W 20/00, H10W 90/00, H10D 84/00, H10W 20/40, H10W 72/00, H10W 40/22, H10W 20/20, H10W 72/20, H10W 72/30, H10W 72/90, H10W 80/00

(54) **THERMAL MANAGEMENT STRUCTURES IN SEMICONDUCTOR DEVICES**
WÄRMEVERWALTUNGSSTRUKTUREN IN HALBLEITERVORRICHTUNGEN
STRUCTURES DE GESTION THERMIQUE DANS DES DISPOSITIFS É SEMI-CONDUCTEURS

(30) Priority: 25.06.2021 US 202117358971
(43) Date of publication of application: 28.12.2022
(73) Proprietor: INTEL Corporation, Santa Clara, CA 95054 (US)
(72) Inventor: Pawashe, Chytra, Portland, 97229 (US); Jiang, Lei, Camas, 98607 (US); Landon, Colin, Portland, 97229 (US); Pantuso, Daniel, Portland, 97229 (US); Ramayya, Edwin, Hillsboro, 97124 (US); Hicks, Jeffrey, Banks, 97106 (US); Koker Aykol, Mehmet, Beaverton, 97008 (US)
(74) Representative: Goddar, Heinz J.

(56) References cited:
- EP-A1- 2 814 053
- EP-A1- 3 203 507
- US-A- 6 017 829
- US-A1- 2012 146 186
- US-A1- 2012 248 621
- US-A1- 2018 138 209
- US-A1- 2018 151 463
- US-A1- 2020 027 898
- US-A1- 2021 013 119
- US-A1- 2021 028 087
- US-A1- 2021 082 873

## Description

### TECHNICAL FIELD

The present invention relates to thermal management structures in semiconductor devices and methods of fabrication thereof.

### BACKGROUND

Heat dissipation from high power regions of circuit is a challenge that can limit device performance. In particular, heat dissipation in bonded substrates can cause heat traps in the vicinity of high-power devices. For example, semiconductor device architectures with interconnects on both sides of the transistors are prone to challenges in heat dissipation because insulator layers can preferentially cause heat traps in the vicinity of high-power devices. Methods are needed to efficiently remove heat from the vicinity of high-power devices.

US 2012/248621 A1 relates to methods of forming bonded semiconductor structures including providing a first semiconductor structure including a device structure, bonding a second semiconductor structure to the first semiconductor structure below about 400° C., forming a through wafer interconnect through the second semiconductor structure and into the first semiconductor structure, and bonding a third semiconductor structure to the second semiconductor structure on a side thereof opposite the first semiconductor structure.

US 2021/013119 A1 relates to a semiconductor structure with a heat dissipation structure including a first device wafer including a front side and a back side.

US 2021/082873 A1 relates to a three dimensional, 3D, integrated circuit, IC, stack, including a first IC die having a first substrate and a first interconnect structure over a frontside of the first substrate; a second IC die having a second substrate and a second interconnect structure over the frontside of the second substrate; and a third IC die vertically between the first and second IC dies and having a third substrate, a third interconnect structure over the frontside of the third substrate, and a third bonding structure over a backside of the third substrate.

US2012/0146186 A1 relates to a thermally controlled refractory metal resistor wherein heat is conducted to a semiconductor substrate by the insertion of multiple metal levels below the resistor, capturing heat rising off the top of the resistor.

### SUMMARY OF THE INVENTION

The invention is defined in the independent claims. Advantageous modifications are set forth in the dependent claims.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Also, various physical features may be represented in their simplified "ideal" forms and geometries for clarity of discussion, but it is nevertheless to be understood that practical implementations may only approximate the illustrated ideals. For example, smooth surfaces and square intersections may be drawn in disregard of finite roughness, corner-rounding, and imperfect angular intersections characteristic of structures formed by nanofabrication techniques. Further, where considered appropriate, reference labels have been repeated among the figures to indicate corresponding or analogous elements.
Figure 1A is a cross-sectional illustration of a device structure including a bonding layer having a plurality of embedded metal structures above a plurality of interconnects in a high-power dissipation region, in accordance with an embodiment of the present disclosure.
Figure 1B is a cross-sectional illustration of a device structure including a bonding layer having a plurality of embedded metal structures above a plurality of interconnects in a high-power dissipation region, in accordance with an embodiment of the present disclosure.
Figure 1C is a cross-sectional illustration of a device structure including a bonding layer having a metallic dopant above a plurality of interconnects, in accordance with an embodiment of the present disclosure.
Figure 1D is an enhanced cross-sectional illustration of a device structure within a device layer.
Figure 2A is a cross-sectional illustration of a device structure including a gridded metal structure above a high-power dissipation region in a device layer, in accordance with an embodiment of the present invention.
Figure 2B is a cross-sectional illustration of a device structure including a via connecting a high-power dissipation region in a device layer below the via to a bonding layer above the via, in accordance with an embodiment of the present invention.
Figure 2C is a cross-sectional illustration of a device structure including a via connecting a first interconnect layer below a device layer to a portion of a substrate above the via, in accordance with an embodiment of the present invention.
Figure 3A is a cross-sectional illustration of a device structure including a dielectric layer having thermally conductive properties below device layer, in accordance with an embodiment of the present disclosure.
Figure 3B is a cross-sectional illustration of a device structure including a plurality of thermal management structures, in accordance with an embodiment of the present disclosure.
Figure 4 is an illustration of flow chart to fabricate a thermal management structure, in accordance with an embodiment of the present disclosure.
Figure 5A is a cross-sectional illustration of a workpiece including a first interconnect layer fabricated over a device layer above a first substrate, in accordance with an embodiment of the present disclosure.
Figure 5B is a cross-sectional illustration of the structure in Figure 5A following the formation of embedded metal structures within a layer including a first dielectric material, in accordance with an embodiment of the present disclosure.
Figure 5C is a cross-sectional illustration of a workpiece including a layer including a second dielectric material formed above a second substrate, in accordance with an embodiment of the present disclosure.
Figure 5D is a cross-sectional illustration of the structures in Figure 5B and Figure 5C following the process to mechanically bond the first substrate with the second substrate, in accordance with an embodiment of the present disclosure.
Figure 5E is a cross-sectional illustration of the structure in Figure 5D following the processing to remove the first substrate and leave the device layer.
Figure 5F is a cross-sectional illustration of the structure in Figure 5E following the formation of a second interconnect layer and a third interconnect layer and a package, in accordance with an embodiment of the present disclosure.
Figure 6A is a cross-sectional illustration of a workpiece including embedded metal structures within a layer including a dielectric material formed above a third substrate, in accordance with an embodiment of the present disclosure.
Figure 6B is a cross-sectional illustration of the structures in Figure 6A and Figure 5B following the process to mechanically bond the third substrate with the first substrate, in accordance with an embodiment of the present disclosure.
Figure 7A is a cross-sectional illustration of the structure in Figure 5E following the formation of a second interconnect layer on the device layer and following the process to form a deep via opening through the second interconnect layer, the device layer, the first interconnect layer, a dielectric layer and a portion of the second substrate, in accordance with an embodiment of the present disclosure.
Figure 7B is a cross-sectional illustration of the structure in Figure 7A following the formation of a via in the deep via opening.
Figure 8 illustrates a computing device in accordance with embodiments of the present disclosure.
Figure 9 illustrates an integrated circuit (IC) structure.

### DETAILED DESCRIPTION

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Also, various physical features may be represented in their simplified "ideal" forms and geometries for clarity of discussion, but it is nevertheless to be understood that practical implementations may only approximate the illustrated ideals. For example, smooth surfaces and square intersections may be drawn in disregard of finite roughness, corner-rounding, and imperfect angular intersections characteristic of structures formed by nanofabrication techniques. Further, where considered appropriate, reference labels have been repeated among the figures to indicate corresponding or analogous elements.

Various configurations of thermal management structures in semiconductor devices and are described. In the following description, numerous specific details are set forth, such as structural schemes and detailed fabrication methods in order to provide a thorough understanding of embodiments of the present disclosure. It will be apparent to one skilled in the art that embodiments of the present disclosure may be practiced without these specific details. In other instances, well-known features, such as transistor operations or memory device operations are described in lesser detail in order to not unnecessarily obscure embodiments of the present disclosure. Furthermore, it is to be understood that the various embodiments shown in the Figures are illustrative representations and are not necessarily drawn to scale.

In some instances, in the following description, well-known methods and devices are shown in block diagram form, rather than in detail, to avoid obscuring the present disclosure. Reference throughout this specification to "an embodiment" or "one embodiment" or "some embodiments" means that a particular feature, structure, function, or characteristic described in connection with the embodiment is included in at least one embodiment of the disclosure. Thus, the appearances of the phrase "in an embodiment" or "in one embodiment" or "some embodiments" in various places throughout this specification are not necessarily referring to the same embodiment of the disclosure. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. It should be understood that these terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical, electrical or in magnetic contact with each other, and/or that the two or more elements co-operate or interact with each other (e.g., as in a cause an effect relationship).

The terms "over," "under," "between," and "on" as used herein refer to a relative position of one component or material with respect to other components or materials where such physical relationships are noteworthy. For example, in the context of materials, one material or material disposed over or under another may be directly in contact or may have one or more intervening materials. Moreover, one material disposed between two materials may be directly in contact with the two layers or may have one or more intervening layers. In contrast, a first material "on" a second material is in direct contact with that second material/material. Similar distinctions are to be made in the context of component assemblies. As used throughout this description, and in the claims, a list of items joined by the term "at least one of" or "one or more of" can mean any combination of the listed terms.

The term "adjacent" here generally refers to a position of a thing being next to (e.g., immediately next to or close to with one or more things between them) or adjoining another thing (e.g., abutting it).

The term "signal" may refer to at least one current signal, voltage signal, magnetic signal, or data/clock signal. The meaning of "a," "an," and "the" include plural references. The meaning of "in" includes "in" and "on."

The term "device" may generally refer to an apparatus according to the context of the usage of that term. For example, a device may refer to a stack of layers or structures, a single structure or layer, a connection of various structures having active and/or passive elements, etc. Generally, a device is a three-dimensional structure with a plane along the x-y direction and a height along the z direction of an x-y-z Cartesian coordinate system. The plane of the device may also be the plane of an apparatus which comprises the device.

As used throughout this description, and in the claims, a list of items joined by the term "at least one of" or "one or more of' can mean any combination of the listed terms.

Unless otherwise specified in the explicit context of their use, the terms "substantially equal," "about equal" and "approximately equal" mean that there is no more than incidental variation between two things so described. In the art, such variation is typically no more than +/-10% of a predetermined target value.

The terms "left," "right," "front," "back," "top," "bottom," "over," "under," and the like in the description and in the claims, if any, are used for descriptive purposes and not necessarily for describing permanent relative positions. For example, the terms "over," "under," "front side," "back side," "top," "bottom," "over," "under," and "on" as used herein refer to a relative position of one component, structure, or material with respect to other referenced components, structures or materials within a device, where such physical relationships are noteworthy. These terms are employed herein for descriptive purposes only and predominantly within the context of a device z-axis and therefore may be relative to an orientation of a device. Hence, a first material "over" a second material in the context of a figure provided herein may also be "under" the second material if the device is oriented upside-down relative to the context of the figure provided. In the context of materials, one material disposed over or under another may be directly in contact or may have one or more intervening materials. Moreover, one material disposed between two materials may be directly in contact with the two layers or may have one or more intervening layers. In contrast, a first material "on" a second material is in direct contact with that second material. Similar distinctions are to be made in the context of component assemblies.

The term "between" may be employed in the context of the z-axis, x-axis or y-axis of a device. A material that is between two other materials may be in contact with one or both of those materials, or it may be separated from both of the other two materials by one or more intervening materials. A material "between" two other materials may therefore be in contact with either of the other two materials, or it may be coupled to the other two materials through an intervening material. A device that is between two other devices may be directly connected to one or both of those devices, or it may be separated from both of the other two devices by one or more intervening devices.

Thermal management within a chip is key to optimal performance. Heat sinks are implemented in traditional chip technology to dissipate heat generated during device operation, where the heat sinks are affixed to a substrate or a package by a thermal compound. When a number of levels of interconnects and device density in a chip is increased thermal performance management within the chip is even more important. One such example of increased levels of interconnects is microprocessors that include interconnects on front as well as on back side of a device layer. In some such examples, transistors and memory devices are electrically coupled with interconnects on an upper level (above contacts) as well as by power delivery networks and other interconnects on a lower level, such as, for example below a level of a substrate of the device layer. Power delivery networks are integral to reliable voltage control in logic and memory devices.

Integration of multiple levels (interconnects and devices) in a chip is result of direct fusion wafer bonding, where insulator layers on uppermost surfaces of two distinct substrates are chemically activated and then brought into contact to form a single insulator layer. Typically, such an insulator layer is directly formed on an interconnect layer. Often devices fabricated on two different substrates are combined onto a single wafer through a direct fusion bonding process. However, when levels of interconnects and density of devices are increased, self-heating in devices is also increased. Typically heat sinks are attached to external portions of a chip above the interconnect levels to dissipate heat from regions of high energy circuitry. However, presence of an insulator layer including thermal and electrically insulting materials can prevent effective heat dissipation to the heat sink.

The inventors have designed structures and layers within a chip for managing thermal performance. Several designs are presented herein as embodiments of different thermal management structures that can be integrated as part of a device structure. The different embodiments, though presented separately, can be implemented in different combinations that include two or more thermal management structures.

In one embodiment, the insulator layer (implemented as a bonding layer) can be integrated with thermally conductive structures that extend up to a full extent of the insulator layer. Such thermally conductive structures are electrically isolated from other interconnect structures present in an adjacent interconnect layer but can be strategically located over regions of the wafer where hot spots can develop during device operation. Such hot spots are often concentrated above regions of high-power density circuitry, circuitry that includes devices involved in routine operation or circuitry that includes a high density of logic or memory devices. High power density may be defined as power density above 1000 W/cm2. The thermally conductive structures can include a metal but facilitate wafer bonding. The thermally conductive structures can be as much as 50% of the overall density of the entire wafer surface.

In a second embodiment, the insulator layer can itself be doped with metallic dopants to promote thermal conductivity. Such dopants can be introduced to various depths within the insulator layer on each bonding substrate. Metallic dopants are injected to a level where the dopants do not electrically interfere with interconnect performance but can help to dissipate heat from the device layer through the interconnect layer.

In a third embodiment, in accordance with the invention, one or more gridded mesh structures including layers of connected vias and metal lines can be placed strategically above each hot spot. In one or more embodiments, the vias and metal lines in the gridded mesh structures have a higher density (at least 2 times greater) compared to a density of vias and metal lines in redundant dummy interconnect structures that they are replacing above the hot spot. The one or more gridded mesh structures are electrically uncoupled from the local device interconnect structures that are adjacent to the one or more gridded mesh structures.

In a fourth embodiment, one or more vias can extend directly from an immediate vicinity of a hot spot to the insulator layer. The vias can have a larger diameter than vias in interconnect structures to promote efficient heat transfer.

In a fifth embodiment, a through via can be utilized to couple heat away from a first interconnect layer below a device layer to the heat sink above a second interconnect layer that is above the device layer. The through via like other thermal management structures is also strategically placed. The via extends through multiple interconnect layers on either side of the device layer, albeit adjacent to a hot spot in the device layer.

In a sixth embodiment, a thermally conductive (yet electrically insulating) material can be implemented between the device layer and a lower-level interconnect to localize heat throughout the device layer.

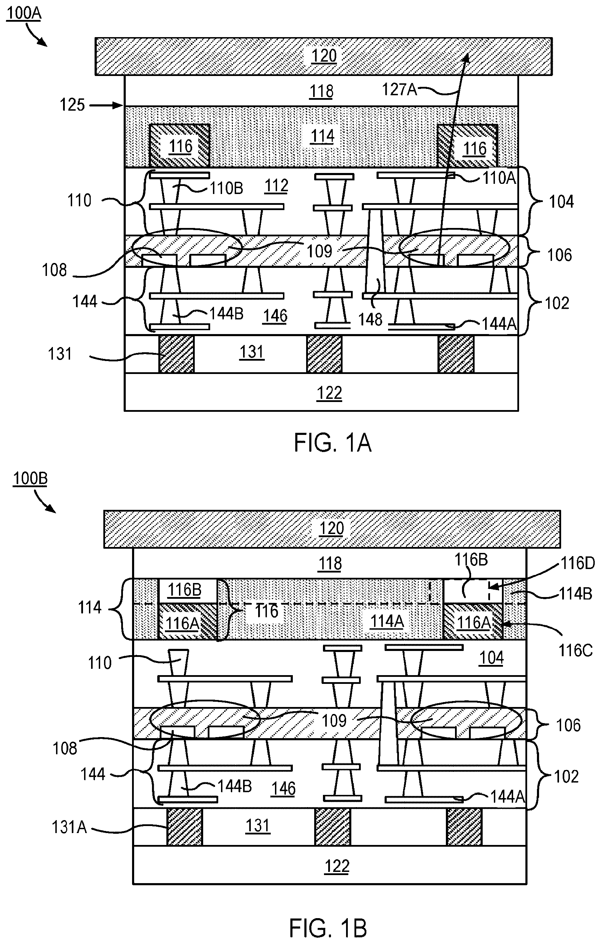

Figure 1A is a cross-sectional illustration of a device structure 100A including an interconnect layer 102, interconnect layer 104, a device layer 106 between the interconnect layer 102 and the interconnect layer 104. In various implementations, the device layer 106 may include logic regions and memory regions, where the logic region may include devices 108 such as transistors and the memory regions may include devices 108 such as transistors coupled with one or memory cells. The device layer 106 includes regions 109 that include high power circuit elements that include a plurality of devices 108 such as, for example, transistors and/or transistors coupled with memory devices. Examples of high-power circuitry include- clocking circuits, cluster of high-speed logic devices and high-speed IO buffers. Power densities that lead to device-level temperature increases are generally in excess of 1000 W/cm2 over a region 109 that has a lateral width of approximately 100 um or less.

The interconnect layer 104 includes a plurality of interconnect structures 110. The interconnect structures 110 may include various routing metallization lines 110A (herein metallization lines 110A) and vias 110B connected to metallization lines 110A within an interlayer dielectric (ILD) 112. The metallization lines 110A are coupled with the various devices in device layer 106 to enable programming of logic and memory circuitry. In general, all the vias 110B in the interconnect layer 104 have a combined density of less than 10% of the interconnect layer 104 and a sum of all the metallization lines 110A have a combined density between 20% and 70% of the interconnect layer 104. The local density of vias 110B and interconnect lines 110A may depend on the circuitry within a given region of the device layer 106.

The device structure 100A further includes a dielectric layer 114 adjacent to the interconnect layer 104. In the illustrative embodiment, the dielectric layer 114 includes plurality of metal structures such as metal structures 116 embedded within the dielectric layer 114. The plurality of metal structures 116 are electrically isolated from interconnect structures 110 but in contact with the ILD 112 of the interconnect layer 104. In exemplary embodiments, each of metal structures 116 are above the region 109 within the device layer 106 that include high power circuit elements described above. The high-power circuit elements can generate large thermal energy from ohmic heating during operation. Generation of large thermal energy can create hot spots within various regions 109 of the device layer as shown. The hot spots can increase die temperature and limit chip performance. The metal structures 116 is an example of a thermal management structure. In different embodiments, the metal structures 116 include blocks of metal that can dissipate the heat generated from the vicinity of regions 109 and provide a conduction path 127A to transport heat to heat sink 120 via substrate 118 adjacent to the dielectric layer 114. The metal structures are physically distant from the regions 109 by a thickness of the interconnect layer 104. The metal structures 116 are substantially confined to locations above regions 109 to minimize the prevalence of metal structures 116 within the dielectric layer 114 and as such span a horizontal distance (along the x-direction) between 1 micron - 10 micron. In exemplary embodiments, the metal structure 116 includes copper, tungsten, molybdenum or ruthenium. In some embodiments, the metal structure includes a liner layer adjacent to the dielectric layer 114 and a fill metal on the liner layer, where the liner layer includes titanium nitride, tantalum nitride, ruthenium nitride, or tantalum. In the illustrative embodiment, the dielectric layer 114 is utilized as a bonding layer to enable fabrication of dual interconnects (interconnects 102 and 104) adjacent to either side of device layer 106. An over-abundance in a number of metal structures 116 can lead to wafer distortion during fabrication.

In the illustrative embodiment, the interconnect layer 102 includes a power delivery network that may, for example, include a plurality of decoupling capacitors. The interconnect layer is coupled to a package 122 through a layer 131 including bumps 131A and solder.

The interconnect layer 102 includes a plurality of interconnect structures 144. The interconnect structures 144 may include various routing metallization lines 144A (herein metallization lines 144A) and vias 144B connected to metallization lines 144A within an interlayer dielectric (ILD) 146. The interconnect structures 144 are coupled with interconnect structures 110 to enable programming of logic and memory circuitry. The interconnect structures 144 may be coupled with interconnect structures 110 by one or more through vias, such as through via 148 that extends from the interconnect layer 102 to interconnect layer 104 through the device layer 106. In some embodiments, such as is shown, the via 148 has a maximum lateral width, that decreases with height, from interconnect layer 102 to interconnect layer 104.

In general, all the vias 144B in the interconnect layer 102 have a combined density of less than 10% of the interconnect layer 102 and a sum of all the metallization lines 144A have a combined density between 20% and 70% of the interconnect layer 104. The local density of vias 144B and interconnect lines 144A may depend on the circuitry within a given region of the device layer 106.

The device structure 100A further includes a heat sink 120 coupled with the substrate. The heat sink 120 is proximate to the dielectric layer 114 and the metal structures 116 and facilitates heat transport away from the regions 109 through the interconnect layer 104, metal structure 116 and substrate 118. The heat sink 120 is distinct from the metal structures 116 which is embedded within the device structure 100A. Heat sink 120 may be a passive metallic structure including a thermally conductive material such as copper affixed to the substrate 118 by a thermal compound.

In the illustrative embodiment, the metal structures 116 extend vertically upward from the interconnect layer 104 into the dielectric layer 114 but not all the way to the substrate 118, which may be indicative of a processing operation utilized to fabricate device structure 100A. As shown, a portion of the dielectric layer 114 is between the metal structure 116 and the substrate 118. The dielectric layer 114 may have a thickness that is between 0.5 microns - 10 microns as measured from an interface 125 between the dielectric layer 114 and the substrate 118.

In other embodiments, such as is shown in the cross-sectional illustration of Figure 1B, the metal structures 116 extends from the interconnect layer 104 to the substrate 118 with no intervening dielectric layer 114 in between. As shown, the dielectric layer 114 includes a dielectric layer portion 114A and a dielectric layer portion 114B on the layer 114A. The dielectric layers 114A and 114B can include a same material or a substantially same material for example, silicon dioxide, silicon carbide, silicon oxynitride, or silicon oxycarbide. As shown, the metal structures 116 have a portion 116A within the dielectric layer 114A and a portion 116B within the dielectric layer 114B. The portions 116A and 116B may be substantially vertically aligned as shown in the illustrative embodiment. In other embodiments, the portions 116A and 116B may be laterally offset as indicated by relative misalignment between sidewalls 116C and 116D of portions 116A and 116B, respectively. In embodiments, the offset may be as much as 100nm.

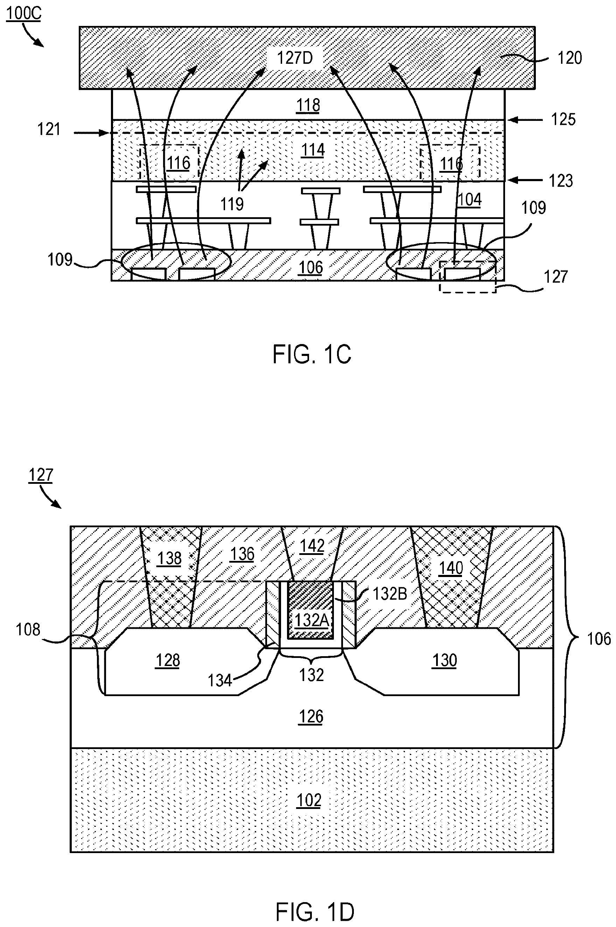

In other embodiments, thermal conductivity away from regions 109 can be achieved by replacing the dielectric layer 114 with a thermally conductive material that is electrically an insulator as shown in Figure 1C. In some such embodiments, the dielectric layer 114 includes one or more metal dopants 119 such as gallium, aluminum or boron. The metal dopants 119 facilitate heat transport across the dielectric layer 114. Pathways for heat conduction across dielectric 114 is illustrated though arrows 127D in the Figure.

The metal dopants have a sufficiently low total density to inhibit charge transfer. The metal dopants 119 may have a dopant concentration between 1e17/cm³ _ 1e20/cm³ which is sufficiently low that dielectric 114 remains an insulator. The metal dopants 119 may be uniformly distributed throughout the volume of the dielectric layer 114 or be localized above regions 109. Depending on embodiments, the metal dopants 119 can also have a density gradient in the dielectric layer 114 that is direct towards or away from the region 109. In some embodiments, the metal dopants 119 are not present at the immediate vicinity of interface 121 between interconnect 104 and dielectric layer 114 and are present between dashed line 123 that is proximate to interface 121 and interface 125 between the dielectric layer 114 and the substrate 118. In some embodiments, the dielectric layer 114 includes one or more metal dopants 119 as well as metal structures 116 (indicated by dashed lines) to additionally facilitate heat transfer. When the dielectric layer 114 includes one or more metal dopants 119, a thickness of the dielectric layer 114 can be between 0.5 microns - 10 microns .

In some embodiments, thermal structures can be integrated into the interconnect layer 104 to enable heat transfer from a location closer to regions 109 than metal structures 116.

Figure 1D is an enhanced cross-sectional illustration of a portion of the device layer 106 in Figure 1C, and the interconnect layer 102. In the enhanced cross-sectional illustration, the device 108 is a transistor 108 which is fabricated on a channel layer 126. Channel layer 126 is part of the device layer 106. In the illustrative embodiment, the channel layer 126 extends uniformly adjacent to the interconnect layer 102, and laterally across the device structure 100C. In embodiments, the channel layer 126 includes a material of the substrate 118 such as single crystal silicon, silicon germanium or germanium. The channel layer 126 may also include a stack including layers of compounds of group III-V materials.

In the illustrative embodiment, transistor 108 includes a source 128, a drain 130 and a gate 132 including a gate electrode 132A and a gate dielectric layer 132B between the channel layer 126 and the gate electrode 132A. A spacer 134 including a dielectric material is adjacent to the gate 132. A dielectric 136 is adjacent to the source 128, gate 132 and drain 130. In the illustrative embodiment, the device layer 106 further includes source contact 138, drain contact 140 and a gate contact 142 coupled with the source 128, drain 130 and gate 132 respectively. The source contact 138, gate contact 142 and drain contact 140 are coupled with various vias 110B and metallization lines 110A in the interconnect structure 110 (not shown).

While transistor 108 has been depicted as part of device structure 100C, transistor 108 including the embodiments described above may be an example of device 108 in Figures 1A and 1B and in various other embodiments described further below.

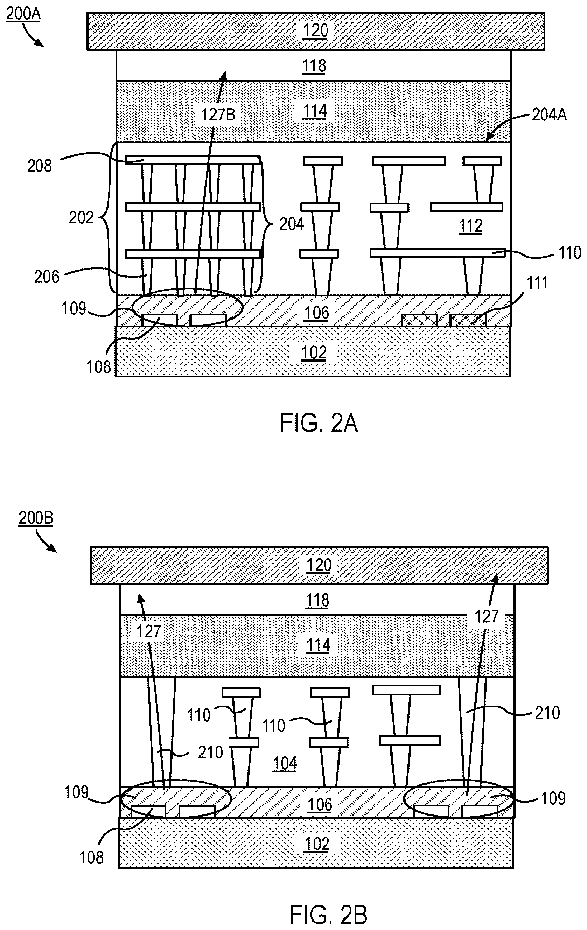

Figure 2A is a cross-sectional illustration of a device structure 200A including interconnect layer 102, device layer 106 including a plurality of devices 108 above interconnect layer 102. In the illustrative embodiment, an interconnect layer 202 is above the device layer 106. The interconnect layer 202 includes interconnect structures 110 within ILD 112, where the interconnect structures 110 are coupled with the plurality of devices 108. In the illustrative embodiment, the device structure 200A further includes a gridded structure 204 including metal lines 208 and vias 206. The gridded structure 204 is an example of a thermal management structure and provides a conduction path 127B to transport heat to heat sink 120 via substrate 118 adjacent to the dielectric layer 114.

The gridded structure 204 is electrically isolated from interconnect structures 110 and extends from above at least some of the plurality of devices 108 towards an uppermost surface 204A of the interconnect layer 202. The presence of gridded structure 204 does not impact the electrical characteristics or functionality of interconnect structures 110. One gridded structure 204 is illustrated above devices 108 and no gridded structure is shown above devices 111. Devices 108 may be elements of a high-power circuit structure described above, that produces a hot spot in region 109, whereas devices 111 may not sufficiently produce a hot spot in region 109 during operation.

In some embodiments, the gridded structure 204 includes a same number of layers as the interconnect structure 110 and may indicate a fabrication technique utilized. However, the density of lines 208 and vias 206 are substantially greater than the density of lines 110A and vias 110B per unit volume of the interconnect layer 202. In general, all the vias 110B in the interconnect structure 110 have a combined density of less than 10% of the interconnect layer 202 and a sum of all the lines 110A have a combined density between 20% and 70% of the interconnect layer 202. In some embodiments, gridded structure 204 includes twice as many layers of metal lines 208 and vias 206 compared to the number of layers in the interconnect structure 110, to increase the metal density of gridded structure 204.

In exemplary embodiments, the lines 208 in the gridded structure 204 has a density per unit volume of the interconnect layer 104 that is at least twice as much as a line density of the lines 110A per unit volume of the interconnect layer 202. In exemplary embodiments, the vias 206 in the gridded structure 204 has a density per unit volume of the interconnect layer 202 that is at least five times as much as a density of the vias 110B per unit volume of the interconnect layer 104.

In the illustrative embodiment, vias 206 are in contact with the device layer 106 and are directly above the region 109 representing a hotspot in the device layer 106, but the gridded structure 204 is not in contact with the devices 108. In other embodiments, an etch stop layer (not shown) is present between the gridded structure 204 and the device layer 106. In some embodiments, the gridded structure also extends to the uppermost surface 204A.

As shown, the device 200A also includes dielectric layer 114 adjacent the interconnect layer 104, a substrate 118 adjacent to the dielectric layer 114, and a heat sink 120 coupled with the substrate 118. The heat sink 120 is distinct from the gridded structure 204.

While not shown, in some embodiments, the dielectric layer 114 may also include metal structures 116 directly above the gridded structure 204. In other embodiments, dielectric layer 114 may include metal dopants designed to effectively transport heat, as discussed above.

In some embodiments, a device structure 200B includes vias spanning all or part of a height of the interconnect layer 104 as illustrated in Figure 2B.

One or more vias 210 may extend upward from region 109 in the vicinity of devices 108. As shown, a single via extends above from each region 109. The vias 210 include a thermally conductive material such as a metal. The via 210 is an example of a thermal management structure and provides a conduction path 127C to transport heat to heat sink 120 via substrate 118 adjacent to the dielectric layer 114. In embodiments, the vias 210 include a material that is the same or substantially the same as the material of the interconnect structures 110 but are electrically redundant. The vias 210 are not coupled with devices 108 or with the interconnect structure 110 and, as such, the presence of vias 210 does not interfere with electrical characteristics or functionality of interconnect structures 110.

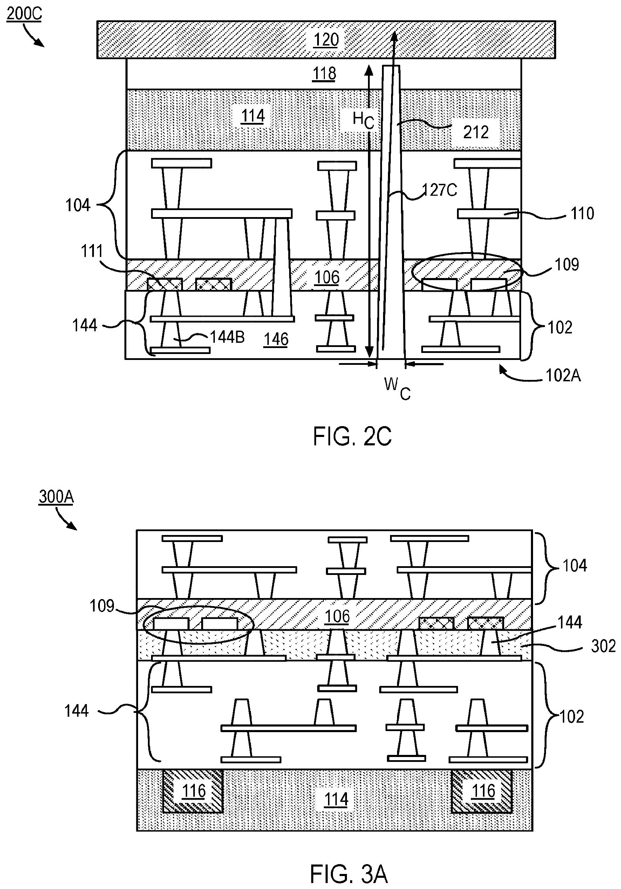

In another embodiment, thermal management is accomplished by insertion of one or more via structures that extends from interconnect layer 102 to within a portion of the substrate 118, as shown in the cross-sectional illustration of Figure 2C. In the illustrative embodiment, via 212 extends from a lower most surface 102A of interconnect 102 to a portion of the substrate 118. The via 212 is not electrically coupled with devices 108 in the device layer 106 or with interconnects 110 or 144. The via 212 may be directly adjacent to region 109 or penetrate region 109 to advantageously provide more efficient heat transfer capabilities. The via 212 may be routed through the interconnect layers 102 or 104 without interfering with electrical operations of interconnect structures in the interconnect layers 102 or 104. In some embodiments, such as is shown, the via 212 has a maximum lateral width Wv, that decreases with height, H_{V}, where H_{V} is measured from lowermost surface 102A.

As discussed above the interconnect layer 102 includes interconnect circuitry that may be utilized for power deliver networks which may be electrically coupled with the devices 108. As such, the interconnect circuitry may have a higher density of routing lines and vias compared to interconnect structures 110. In some embodiments, the region 109 may be expanded to include portions of the interconnect layer 102 in the vicinity of the devices 108. Typically interconnect layer 102 also includes an ILD 146 that is both thermally and electrically insulating and may not dissipate heat away from the interconnect layer 102 as efficiently as desirable. In some embodiments, an additional layer may be inserted between the device layer 106 and the interconnect layer 102 that can facilitate thermal transport yet provide electrical insulation at least as adequately as the ILD 146.

Figure 3A is a cross-sectional illustration of a device structure 300 that includes an insulator 302 between interconnect layer 102 and device layer 106. As illustrated, the interconnect layer 102 includes interconnect structures 144 that extends through the insulator layer into the device layer. Examples of insulator 302 that provide electrical insulation, but thermal conductivity include materials such as boron nitride, aluminum nitride, composites, Al2O3-graphene nanocomposites, silicon carbide or diamond. Depending on the choice of material, the insulator 302 has a thickness that is between a few monolayers to 10 nm. Addition of insulator 302 adjacent to the devices 108, can enable heat generated from devices 108 such as transistors to homogenize locally across the device layer 106, advantageously reducing transistor operating temperatures. As shown, portions of the interconnect structure 144 may be integrated within the insulator 302.

Some of the materials of the insulator 302 may introduce capacitance to devices 108. In some such embodiments, the device 108 may include a material of the substrate 118 to provide a buffer between the insulator 302 and the device 108. For example, the device 108 may include transistors having a channel layer that is monocrystalline silicon. In some such embodiments, the channel layer may extend uniformly between the device and the insulator 302 .

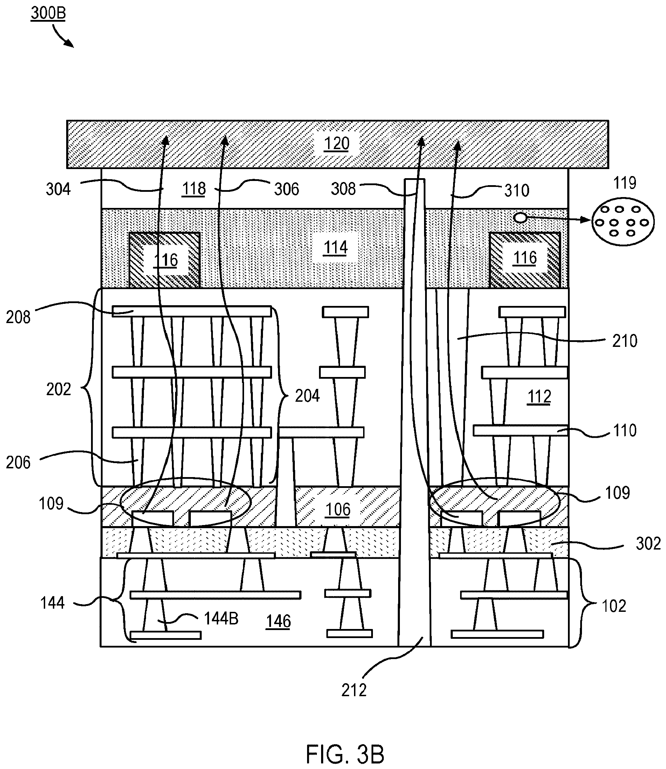

Figure 3B is a cross-sectional illustration of a device 300B that includes a combinations of different thermal management structures described above, in accordance with an embodiment of the present disclosure. The device 300B includes metal structures 116, gridded structure 204, vias 210 and via 212 described in association with Figures 1A-1B, 2A, 2B, 2C in addition to the insulator 302 . Also illustrated is the inclusion of metal dopants 119 in dielectric layer 114 as described in association with Figure 1C.

Various conduction paths are illustrated to transport heat through various thermal management structures to heat sink 120 via substrate 118. Gridded structure 204 provides a conduction path 304 to transport heat from region 109 through metal structure 116 to heat sink 120. Gridded structure 204 provides a conduction path 306 to transport heat from region 109 to heat sink 120. Via structure 212 provides a conduction path 308 to transport heat from region 109 through metal structure 116 to heat sink 120 and via structure 210 provides a conduction path 304 to transport heat from region 109 through metal structure 116 to heat sink 120. Thus, two or more thermal management structures can be implemented to effectively transport heat away from a plurality of regions 109.

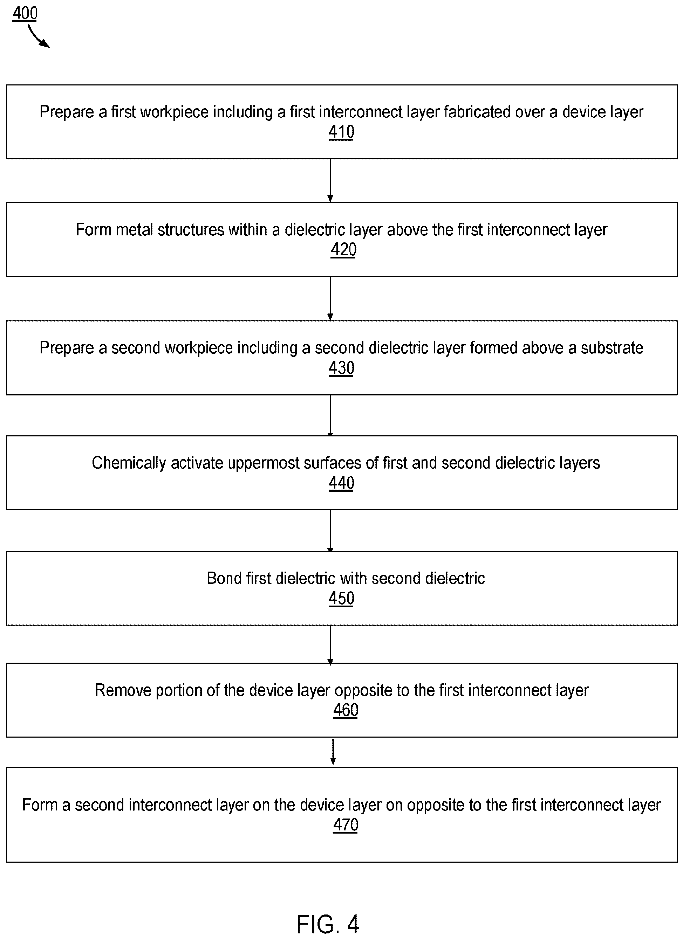

Figure 4 is an illustration of a flow chart to fabricate a thermal management structures, according to embodiments of the present disclosure. In one embodiment, the method 400 begins at operation 410 by preparing a workpiece including a first interconnect layer fabricated over a device layer. The method 400 continues at operation 420 following the formation of metal structures within a dielectric layer above the first interconnect layer. The method 400 continues at operation 430 with the preparation of a second workpiece including a second dielectric layer formed above a substrate. The method 400 continues at operation 440 with chemical activation of uppermost surfaces of the first and the second dielectric layers. The method 400 continues at operation 450 with bonding the first dielectric layer to the second dielectric layer by bringing into contact uppermost surfaces of the first and the second dielectric layers. The method 400 continues at operation 460 with a process to remove portion of the device layer opposite to the first interconnect layer. The method 400 ends at operation 470 with the formation of a second interconnect layer including interconnect structures above the device layer and a package above the third interconnect layer.

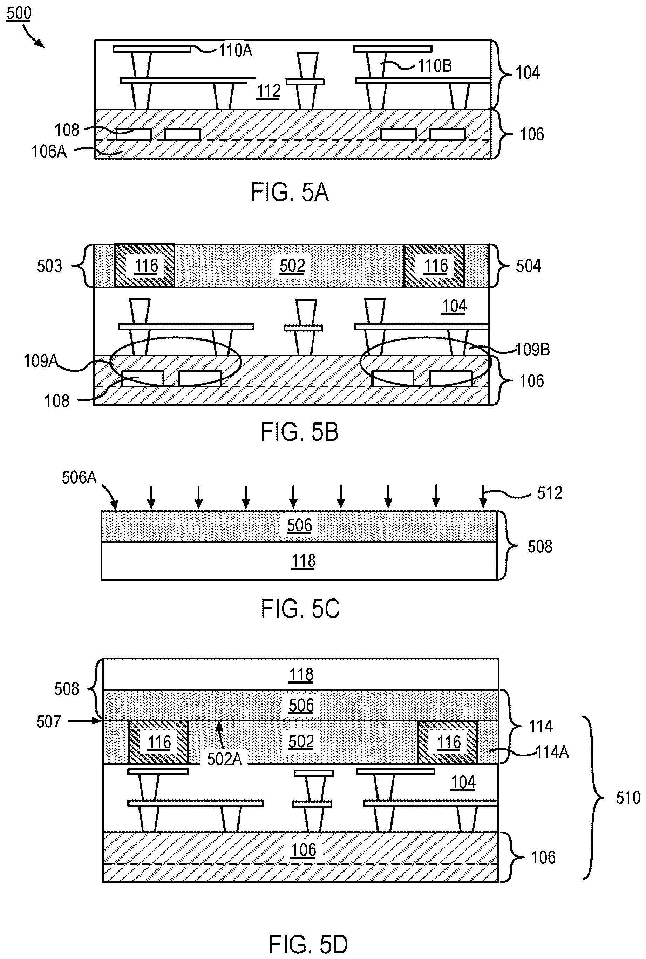

Figure 5A is cross-sectional illustration of a workpiece 500 including a plurality of devices formed within a device layer 106, and a plurality of interconnects formed above the device layer 106 and coupled with one or more of the devices 108, in accordance with an embodiment of the present disclosure. In some embodiments, the device layer 106 includes a substrate portion 106A below the devices 108. In some such embodiments, devices 108 are transistor devices 108 or memory devices coupled with transistors 108. Examples of transistor devices 108 includes fin-FET (field effect transistor) or a nanowire architectures having a channel layer that includes monocrystalline silicon, SiGe, or Ge. Depending on embodiments, a silicon, SiGe, or Ge channel layer is present below discrete transistor devices 108 or continuously present across the entire device layer 106.

After the devices 108 are fabricated, the interconnect layer 104 is fabricated. In an embodiment, interconnect structures are formed by depositing an ILD 112 on the device layer 106 and forming vias 110B by patterning openings and filling with a conductive material such as copper. Metallization lines 110Amay be formed by a dual damascene process on a level above the vias 110B.

Figure 5B is a cross-sectional illustration of the structure in Figure 5A following the formation of embedded metal structures 116 within a dielectric layer 502, in accordance with an embodiment of the present disclosure. In an embodiment, the dielectric layer 502 is blanket deposited by a plasma enhanced chemical vapor deposition (PECVD) or a chemical vapor deposition (CVD) process. In an embodiment, the dielectric layer 502 includes silicon and one or more of nitrogen, oxygen and carbon, for example, silicon nitride, silicon dioxide, carbon doped silicon nitride, silicon oxynitride or silicon carbide.

Openings may be formed in the dielectric layer 502 by plasma etch process. The openings 503 and 504 define a location where metal structures 116 will be formed. The locations are chosen based on regions 109 that will be formed during device operation. In the illustrative embodiment, the openings 503 and 504 are formed above plurality of devices 108 in regions 109A and 109B respectively. A metal is then deposited into the openings 503 and 504, on the dielectric layer 502, and planarized to form metal structures 116. A chemical mechanical polish (CMP) process may be utilized to perform a planarization process. In exemplary embodiments, dielectric layer 502 is the same or substantially the same as dielectric 114.

Figure 5C is a cross-sectional illustration of a workpiece including a dielectric layer 506 formed above substrate 118 in accordance with an embodiment of the present disclosure. In an embodiment, the dielectric layer 506 includes a material that is the same or substantially the same as the material of the dielectric layer 502. Dielectric layer 506 may be blanket deposited by a plasma enhanced chemical vapor deposition (PECVD) or a chemical vapor deposition (CVD) process on a surface of the substrate 118. The dielectric layer 506 may be deposited to a nominal thickness between 5 nm and 10 nm to prevent thermal insulation within the dielectric layer 506 during operation.

After deposition, a chemical treatment of wafer 508 (the dielectric layer 506 and substrate 118) may be performed. In an embodiment, the chemical treatment includes a wet chemical reaction. The wet chemical process may involve treatment of wafer 508 with chemistries which activate the dielectric surface 506A. Activation of the dielectric surface 506A may be achieved by a variety of chemical methods and is characterized by an increase in bonding energy between dielectric surface 506A and a compatible uppermost dielectric surface of a similar dielectric material. One method of activation may be to modify the dielectric surface 506A with functional groups that have a strong binding energy with a dielectric surface on an uppermost portion of the wafer to be bonded to wafer 508. In another embodiment, the chemical treatment includes performing plasma activation (denoted by arrows 512) of the dielectric surface 506A.

Figure 5D is a cross-sectional illustration of the structures in Figure 5B and Figure 5C following the process to mechanically bond wafer 508 with wafer 510. The bonding process involves aligning structures, such as alignment marks, in wafer 508 with structures in wafer 510. Alignment marks may be formed in the dielectric layer 506 and in dielectric 502 post deposition to facilitate alignment. Prior to the bonding process, dielectric surface 502A may be chemically treated in a same or a substantially same manner as the dielectric surface 506A. In an embodiment, the chemical treatment of wafer 510 includes a wet chemical reaction and is performed as part of the planarization process. The chemical does not materially impact thermal qualities of the metal structure 116.

Any topography at a bond interface 507 between surface 506A of dielectric 506 and surface 502A of dielectric layer 502 may result in voiding. Voids are a source of reliability concern for integrated circuits. The number and size of voids is dependent on variation in topography of surfaces 502A and 506A, material properties (including adhesion energy) of the dielectric layers 502 and 506, and material properties of the metal structures 116. Increasing the adhesion energy of the bonded, but unannealed wafers 508 and 510 may reduce the number and size of voids. Plasma activation, described above, is one method that may increase the adhesion energy and decrease voiding by changing surface composition at bond interface 507.

The lateral width of the metal structures 116 is chosen to provide adequate thermal conductivity to facilitate heat transfer away from the regions 109A and 109B. It is desirable to keep the cross-sectional area of the top surface of the metal structures 116 to be sufficiently small to prevent thermal stress fractures during the bonding process between dielectric surface 506A and metal structure 116. Thermal stresses may arise because of a difference in the material properties of the dielectric 506 and metal structure 116. In some embodiments, to prevent thermal stress fracture during wafer bonding, a dielectric layer having a thickness of 5 nm or less may be deposited on top surfaces of the dielectric layer 502 and metal structures 116, where the dielectric layer includes a material that is the same or substantially the same as the material of the dielectric layer 502.

In the illustrative embodiment, the wafer bonding process forms a dielectric layer 114 that includes dielectric 502 and 506 and metal structures between substrate 118 and device layer 106.

In other embodiments, wafer 508 does not include the dielectric layer 506. In some such embodiments, substrate 118 is bonded directly with a wafer including a dielectric layer on a top surface such as wafer 510.

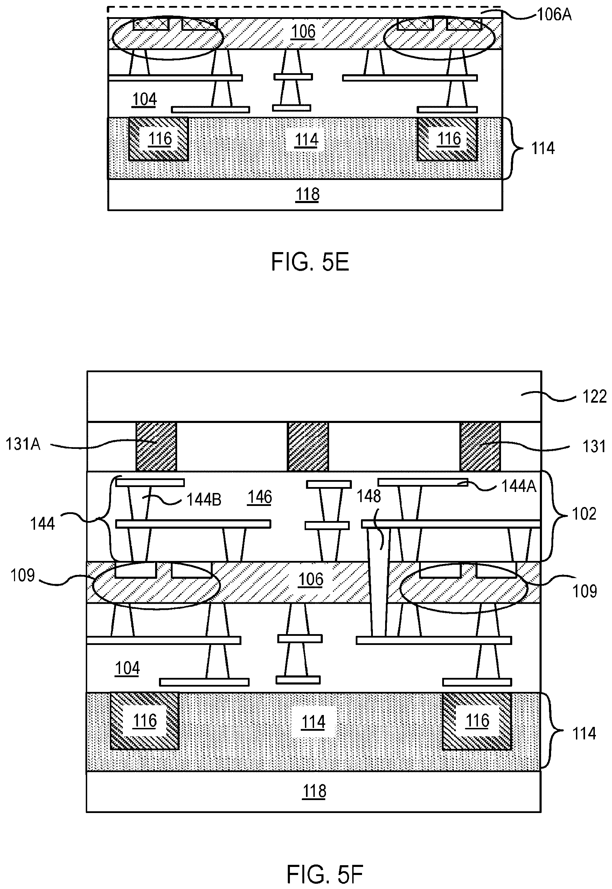

Figure 5E is a cross-sectional illustration of the structure in Figure 5D following the processing to remove the substrate portion 106A from above the device layer 106. In an embodiment, a CMP process, a wet chemical process, a plasma etch process, or a combination thereof may be utilized to remove the substrate portion 106A from above the device layer 106. In some embodiments, portions of the substrate material may remain as part of the device layer 106. In one such embodiment, the substrate portion 106A includes monocrystalline silicon and the devices 108 include fin-FET or silicon nanowire transistors in logic region and fin-FET or silicon nanowire transistors coupled with one or more memory elements in a memory region of the device layer 106.

Figure 5F is a cross-sectional illustration of the structure in Figure 5E following the formation of an interconnect layer 102 on the device layer 106 and an interconnect layer 131 and a package 122 on the interconnect layer 131. In an embodiment, the interconnect layer 131 includes metallic bumps 131A and solder.

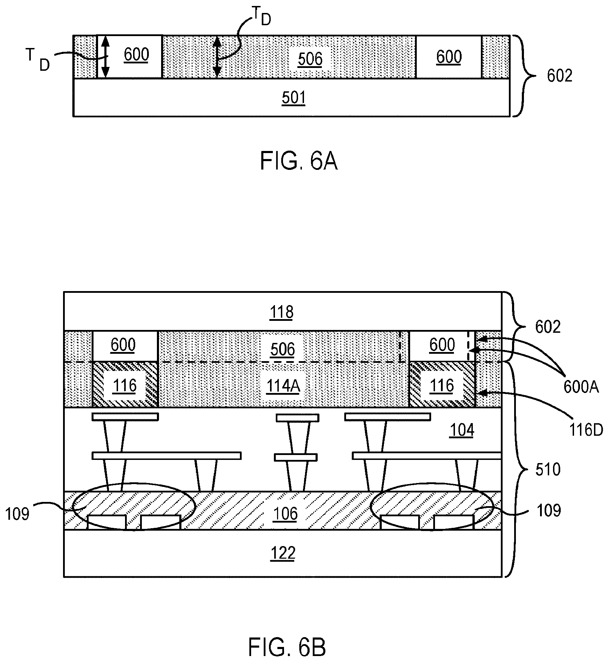

Figure 6A is a cross-sectional illustration of the structure in Figure 5C following the formation of embedded metal structures 600 within the dielectric layer 506, formed above substrate 118, in accordance with an embodiment of the present disclosure. In an embodiment, the process to form embedded metal structures 600 is substantially the same as the process utilized to form metal structures 116 in described in association with Figure 5B. Referring again to Figure 6A, embedded metal structures 600 may have one or more properties of the metal structures 116. It is to be appreciated that substantial number of embedded metal structures 600 are formed in locations on the substrate 118 that correspond 1:1 to locations of metal structures 116 formed on wafer 510 (Figure 5B). The embedded metal structures 600 has a same or a substantially same thickness, T_{M}, as a thickness, T_{D}, of the dielectric layer 506.

Figure 6B is a cross-sectional illustration of the structures in Figure 6A and Figure 5B following the process to mechanically bond wafer 602 with wafer 510, in accordance with an embodiment of the present disclosure. In the illustrative embodiment, the method utilized to mechanically bond wafer 602 with wafer 510 is substantially the same as that utilized to bond wafer 508 with wafer 510 described in association with Figure 5D. The resultant structure after the bonding process illustrates device structure 100B (illustrated in Figure 1B).

In exemplary embodiments, structures in wafer 602 are aligned with structures in wafer 510. Typically, alignment is performed by aligning alignment structures located on each wafer 510 and 602. In some embodiments, wafer 510 may be misaligned relative to wafer 602. In some such embodiments, the metal structures 600 may be displaced laterally relative to metal structures 116 as shown, where sidewall 600A of metal structure 600 is vertically misaligned from sidewall 116D of metal structure 116. The misalignment may be less than 3nm or by as much as 100 nm and does not materially impact bonding between wafers 510 and 602 or performance of combined metal structures 116 and 600 as a thermal management structure.

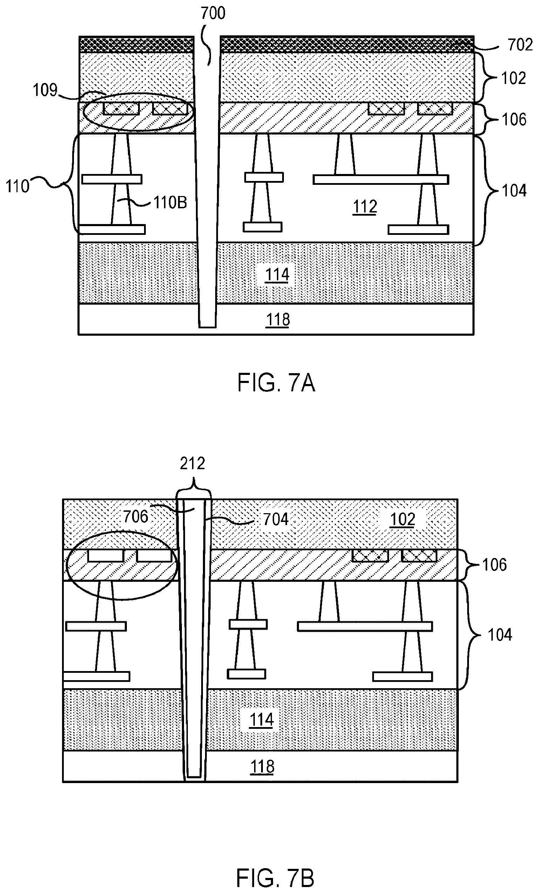

Figure 7A is a cross-sectional illustration of the structure in Figure 5E following the formation of interconnect layer 102 on the device layer 106 and following the process to form a via opening 700 through the interconnect layer 102, the device layer 106, the interconnect layer 102, dielectric layer 114 and a portion of the substrate 118, in accordance with an embodiment of the present disclosure.

In an embodiment, a mask 702 may be formed by a lithographic process on the interconnect layer 102. A plasma etch may be utilized to form the via opening 700. In exemplary embodiments, the via opening 700 is adjacent to one or more regions 109. In the illustrative embodiment, one via opening 700 is shown adjacent to single region 109 where the via opening 700 has a shape that tapers with depth. It is to be appreciated that the taper in profile of the via opening 700 is opposite to tapers in the profiles of vias 110B formed in interconnect layer 104. The via opening 700 does not expose any interconnect structures within interconnect layer 102, devices 108 within device layer 106, or interconnect structures 110 within interconnect layer 104. As shown, via opening 700 is also partially formed in the substrate. Extending via opening 700 into the substrate 118 enables a heat transfer structure to be formed adjacent to a heat sink that will attached below substrate 118 (or above substrate as shown in Figure 2C.

Figure 7B is a cross-sectional illustration of the structure in Figure 7A following the formation of via 212 in the via opening 700. In an embodiment, one or more metals may be deposited into the via opening 700. In an exemplary embodiment, a liner layer 704 including ruthenium, tantalum nitride or ta may be used as a liner in the via opening 700 followed by deposition of a metal fill 706 such as copper, tungsten or molybdenum on the liner layer 704. The liner layer 704 also serves as a barrier layer again copper diffusion into a vicinity of the devices 108. After deposition process, the liner layer 704 and the fill metal are polished and removed to form via 212 as is shown.

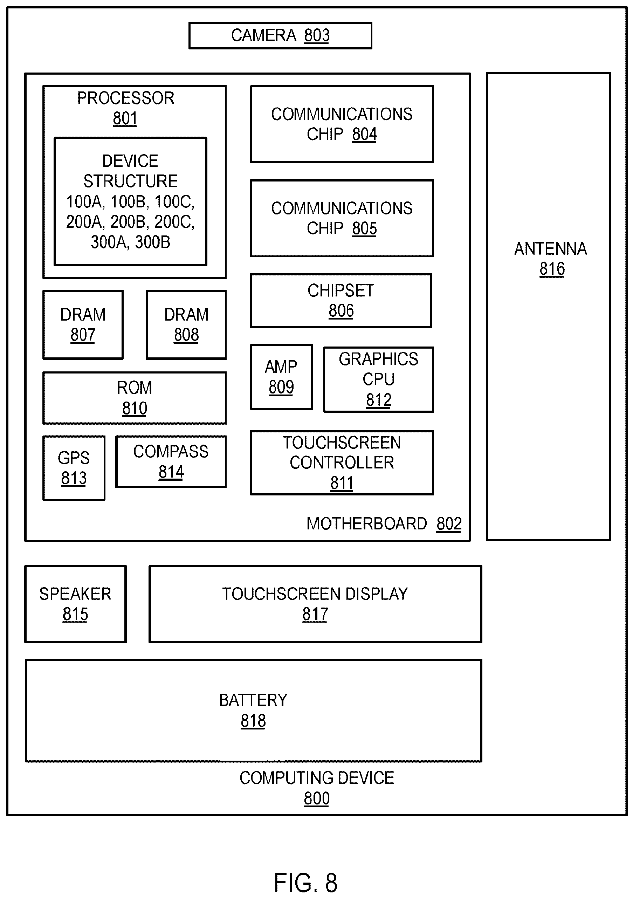

Figure 8 illustrates a computing device 800 in accordance with embodiments of the present disclosure. As shown, computing device 800 houses a motherboard 802. Motherboard 802 may include a number of components, including but not limited to a processor 801 and at least one communications chip 804 or 805. Processor 801 is physically and electrically coupled to the motherboard 802. In some implementations, communications chip 805 is also physically and electrically coupled to motherboard 802. In further implementations, communications chip 805 is part of processor 801.

Depending on its applications, computing device 800 may include other components that may or may not be physically and electrically coupled to motherboard 802. These other components include, but are not limited to, volatile memory (e.g., DRAM), non-volatile memory (e.g., ROM), flash memory, a graphics processor, a digital signal processor, a crypto processor, a chipset 806, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

Communications chip 805 enables wireless communications for the transfer of data to and from computing device 800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communications chip 805 may implement any of a number of wireless standards or protocols, including but not limited to Wi-Fi (IEEE 801.11 family), WiMAX (IEEE 801.11 family), long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 8G, and beyond. Computing device 800 may include a plurality of communications chips 804 and 805. For instance, a first communications chip 805 may be dedicated to shorter range wireless communications such as Wi-Fi and Bluetooth and a second communications chip 804 may be dedicated to longer range wireless communications such as GPS, EDGE, GPRS, CDMA, WiMAX, LTE, Ev-DO, and others.

Processor 801 of the computing device 800 includes an integrated circuit die packaged within processor 801. In some embodiments, the integrated circuit die of processor 801 includes non-volatile memory devices, one or more device structure such as device structures 100A, 100B, 100C, 200A, 200B, 200C, 300A or 300B that include thermal management structures as described in association with Figures 1A-1C, 2A-B, 3A or 3B, respectively. Referring again to Figure 8, the term "processor" may refer to any device or portion of a device that processes electronic data from registers and/or memory to transform that electronic data into other electronic data that may be stored in registers and/or memory.

Communications chip 805 also includes an integrated circuit die packaged within communication chip 805. In another embodiment, the integrated circuit die of communications chips 804, 805 includes one or more interconnect structures, non-volatile memory devices, capacitors. Depending on its applications, computing device 800 may include other components that may or may not be physically and electrically coupled to motherboard 802. These other components may include, but are not limited to, volatile memory (e.g., DRAM) 807, 808, non-volatile memory (e.g., ROM) 810, a graphics CPU 812, flash memory, global positioning system (GPS) device 813, compass 814, a chipset 806, an antenna 816, a power amplifier 809, a touchscreen controller 811, a touchscreen display 817, a speaker 815, a camera 803, and a battery 818, as illustrated, and other components such as a digital signal processor, a crypto processor, an audio codec, a video codec, an accelerometer, a gyroscope, and a mass storage device (such as hard disk drive, solid state drive (SSD), compact disk (CD), digital versatile disk (DVD), and so forth), or the like. In further embodiments, any component housed within computing device 800 and discussed above may contain a stand-alone integrated circuit memory die that includes one or more arrays of nonvolatile memory devices.

In various implementations, the computing device 800 may be a laptop, a netbook, a notebook, an Ultrabook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, or a digital video recorder. In further implementations, the computing device 800 may be any other electronic device that processes data.

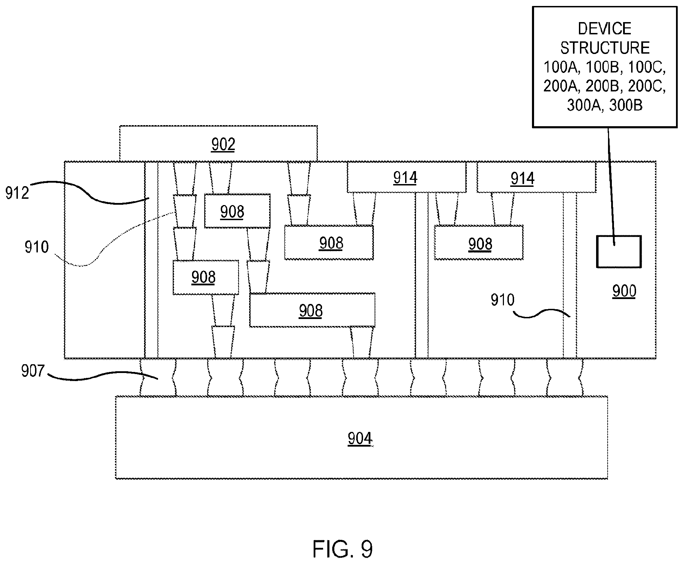

Figure 9 illustrates an integrated circuit (IC) structure 900 that includes one or more embodiments of the disclosure. The integrated circuit (IC) structure 900 is an intervening substrate used to bridge a first substrate 902 to a second substrate 904. The first substrate 902 may be, for instance, an integrated circuit die. The second substrate 904 may be, for instance, a memory module, a computer mother, or another integrated circuit die. Generally, the purpose of an integrated circuit (IC) structure 900 is to spread a connection to a wider pitch or to reroute a connection to a different connection. For example, an integrated circuit (IC) structure 900 may couple an integrated circuit die to a ball grid array (BGA) 907 that can subsequently be coupled to the second substrate 904. In some embodiments, the first substrate 902 and the second substrate 904 are attached to opposing sides of the integrated circuit (IC) structure 900. In other embodiments, the first substrate 902 and the second substrate 904 are attached to the same side of the integrated circuit (IC) structure 900. And in further embodiments, three or more substrates are interconnected by way of the integrated circuit (IC) structure 900.

The integrated circuit (IC) structure 900 may be formed of an epoxy resin, a fiberglass-reinforced epoxy resin, a ceramic material, or a polymer material such as polyimide. In further implementations, the integrated circuit (IC) structure may be formed of alternate rigid or flexible materials that may include the same materials described above for use in a semiconductor substrate, such as silicon, germanium, and other group III-V and group IV materials.

The integrated circuit (IC) structure may include metal interconnects 908 and vias 910, including but not limited to through-silicon vias (TSVs) 912. The integrated circuit (IC) structure 900 may further include embedded devices 914, including both passive and active devices. Such embedded devices 914 include capacitors, resistors, inductors, fuses, diodes, transformers, device structure including transistors. The integrated circuit (IC) structure 900 may further include embedded devices such as one or more resistive random-access devices, sensors, and electrostatic discharge (ESD) devices and one or more device structures such as device structure 100A, 100B, 100C, 200A, 200B, 200C, 300A or 300B that include thermal management structures as described in association with Figures 1A-1C, 2A-B, 3A or 3B, respectively. Referring again to Figure 9, more complex devices such as radiofrequency (RF) devices, power amplifiers, power management devices, antennas, arrays, sensors, and MEMS devices may also be formed on the integrated circuit (IC) structure 900.

The following examples are provided as additional information. They are not to be construed as defining the invention. The invention is defined in the claims.

Example 1: A device structure includes a first interconnect layer, a second interconnect layer including interconnect structures within a dielectric material, a device layer including a plurality of devices, where the device layer is between the first interconnect layer and the second interconnect layer. A dielectric layer is adjacent the second interconnect layer on a side opposite the first interconnect layer, where the dielectric layer includes one or more of metallic dopants or a plurality of metal structures, where the metallic dopants or the plurality of metal structures are electrically isolated from the interconnect structures but in contact with the dielectric material and where the metallic dopants or the individual ones of the plurality of metal structures are above a region comprising at least some of the plurality of devices. A substrate is adjacent the dielectric layer .

Example 2: The device structure according to example 1, where the dielectric layer further includes a first dielectric layer, a second dielectric layer on the first dielectric layer, a first plurality of metal structures within the first dielectric layer and a second plurality of metal structures within the second dielectric layer, where the second plurality of metal structures is substantially vertically aligned with the first plurality of metal structures, and where the first plurality of metal structures and the second plurality of metal structures extend between the first interconnect layer and the substrate.

Example 3: The device structure according to any of one examples 1 through 2, where individual ones of the plurality of metal structures extends from an uppermost surface of the second interconnect layer into the dielectric layer, and where a portion of the dielectric layer is between the individual ones of the plurality of metal structures and the substrate.

Example 4: The device structure according to any of one examples 1 through 3, where the dielectric layer includes metal dopants, the metal dopants including gallium, aluminum or boron, and where the density of the metal dopants is between 1e17/cm³ _ 1e20/cm³.

Example 5: The device structure according to any of one examples 1 through 4, where the dielectric layer has a thickness between 0.5 microns and 10 microns.

Example 6: The device structure according to any of one examples 1 through 5, where the first interconnect layer includes a gridded structure, the gridded structure including first lines and first vias, where the gridded structure is electrically isolated from interconnect structures including second lines and second vias, and where the gridded structure extends from above the plurality of devices towards the dielectric layer.

Example 7: The device structure according to any of one examples 1 through 6, where the first lines have a first line density per unit volume of the second interconnect layer, where the second lines have a second line density per unit volume of the second interconnect layer, where the first vias have a first via density per unit volume of the second interconnect layer, where the second vias have a second via density per unit volume of the second interconnect layer, where the first line density is greater than two times the second line density and where the first via density is greater than five times the second via density.

Example 8: The device structure according to any of one examples 1 through 7, where the device structure further includes one or more via structures extending between the bonding layer and the device layer, where the one or more via structures are not in contact with one or more devices in the device layer or interconnect structures in the interconnect layer.

Example 9: The device structure according to any of one examples 1 through 8, where the device structure further includes one or more via structures extending from within a portion of the substrate to the first interconnect layer, where the one or more via structures are adjacent to but not in contact with some of the plurality of devices and where the one or more via structures are not in contact with the interconnect structures in the second interconnect layer or with interconnect structures in the first conductive layer.

Example 10: The device structure according to any of one examples 1 through 9, where the dielectric layer is a first dielectric layer, and the device structure further includes a third dielectric layer between the device layer and the first interconnect layer, the third dielectric layer including nitrogen and one or more of boron or aluminum, a compound including aluminum, oxygen and graphene nanocomposites, a compound of silicon and carbon, or diamond, and where interconnects in the first interconnect layer extend to the device layer through the third dielectric layer.

Example 11: The device structure according to any of one examples 1 through 10, where the devices include a plurality of transistors, and where each of the transistors includes a respective channel layer, where the channel layer includes a material that is essentially the material of the substrate, and where the material is single crystalline silicon.

Example 12: A device structure includes a first interconnect layer, a device layer including a plurality of devices, where the device layer is above first interconnect layer. A second interconnect layer is above the device layer, where the second interconnect layer includes interconnect structures that is coupled with the plurality of devices and a gridded structure including metal lines and vias, where the gridded structure is electrically isolated from interconnect structures and where the gridded structure extends from above at least some of the plurality of devices towards an uppermost surface of the second interconnect layer. A dielectric layer is adjacent the second interconnect layer, a substrate is adjacent to the dielectric layer and a heat sink is coupled with the substrate.

Example 13: The device structure according to example 12, where the vias are first vias and the lines are first lines and where the interconnect structures include second lines and second vias, where the first lines have a first line density per unit volume of the second interconnect layer, where the second lines have a second line density per unit volume of the second interconnect layer, where the first vias have a first via density per unit volume of the second interconnect layer, where the second vias have a second via density per unit volume of the second interconnect layer, where the first line density is greater than two times the second line density and where the first via density is greater than five times the second via density.

Example 14: The device structure according to any of one examples 12 through 13, where the device structure further includes one or more via structures extending between the bonding layer and the device layer, where the one or more via structures are not in contact with one or more devices in the device layer or interconnect structures in the interconnect layer.

Example 15: The device structure according to any of one examples 12 through 14, where the device structure further includes one or more second via structures extending from within a portion of the substrate to the first interconnect layer, where the one or more second via structures are adjacent to but not in contact with some of the plurality of devices and wherein the second one or more via structures are not in contact with the interconnect structures in the second interconnect layer or with interconnect structures in the first conductive layer.

Example 16: The device structure according to any of one examples 12 through 15, where the dielectric layer includes metal dopants including gallium, aluminum or boron and where the density of the metal dopants is between 1e17/cm³ ₋1e20/cm³.

Example 17: The device structure according to any of one examples 12 through 16, where the dielectric layer has a thickness between 0.5 microns - 10 microns.

Example 18: The device structure according to any of one examples 12 through 17, where the dielectric layer is a first dielectric layer, and the device structure further includes a second dielectric layer between the device layer and the first interconnect layer, the second dielectric layer including nitrogen and one or more of boron or aluminum, a compound including aluminum, oxygen and graphene nanocomposites, a compound of silicon and carbon, or diamond, and where interconnects in the first interconnect layer extend to the device layer through the dielectric.

Example 19: A system includes a display, an antenna, a processor coupled to the antenna, where the processor includes a device structure that includes a first interconnect layer, a second interconnect layer including interconnect structures within a dielectric material, a device layer including a plurality of devices, where the device layer is between the first interconnect layer and the second interconnect layer. A dielectric layer is adjacent the second interconnect layer on a side opposite the first interconnect layer, where the dielectric layer includes one or more of metallic dopants or a plurality of metal structures, where the plurality of metal structures is electrically isolated from the interconnect structures but in contact with the dielectric material and where individual ones of the plurality of metal structures are above a region including at least some of the plurality of devices. A substrate is adjacent the dielectric layer and a heat sink is coupled with the substrate.

Example 20: The system according to example 19, the system further including a battery and where the first interconnect layer includes a gridded structure, the gridded structure includes first lines and first vias, where the gridded structure is electrically isolated from interconnect structures including second lines and second vias, and where the gridded structure extends from above the plurality of devices towards the dielectric layer.

Device structures including thermal management structures are described herein. In the above description, for purposes of explanation, numerous specific details are set forth in order to provide a thorough understanding of certain embodiments. It will be apparent, however, to one skilled in the art that certain embodiments can be practiced without these specific details. In other instances, structures and devices are shown in block diagram form in order to avoid obscuring the description.

## Claims

1. A integrated circuit, IC, device structure comprising:
a first interconnect layer (102);
a second interconnect layer (104) comprising interconnect structures within a dielectric material;
a device layer (106) comprising a plurality of devices, the device layer between the first interconnect layer (102) and the second interconnect layer (104);
one or more dielectric layers (114) adjacent the second interconnect layer (104) on a side opposite the first interconnect layer (102), the dielectric layers (114) comprising one or more of metallic dopants or a plurality of metal structures, wherein the metallic dopants or a plurality of metal structures are electrically isolated from the interconnect structures but in contact with the dielectric material and wherein the metallic dopants or individual ones of the plurality of metal structures are above at least some of the plurality of devices; and
a substrate (118) adjacent to the dielectric layers (114),
wherein the first interconnect layer (102) comprises a gridded structure (204), the gridded structure (204) comprising first lines and first vias, wherein the gridded structure (204) is electrically isolated from interconnect structures comprising second lines and second vias, and **characterized in that** the gridded structure (204) extends from above the plurality of devices toward the one or more dielectric layers (114).

2. The IC device structure of claim 1, wherein the one or more dielectric layers further comprise:
a first dielectric layer;
a second dielectric layer on the first dielectric layer;
a first plurality of metal structures within the first dielectric layer; and
a second plurality of metal structures within the second dielectric layer, the second plurality of metal structures substantially vertically aligned with the first plurality of metal structures, and wherein the first plurality of metal structures and the second plurality of metal structures extend between the first interconnect layer and the substrate.

3. The IC device structure of claim 2, further comprising a third dielectric layer between the device layer and the first interconnect layer, the third dielectric layer comprising nitrogen and one or more of boron or aluminum, a compound comprising aluminum, oxygen and graphene nanocomposites, a compound of silicon and carbon, or diamond, and wherein interconnects in the first interconnect layer extend to the device layer through the third dielectric layer.

4. The IC device structure of any one of claims 1-3, wherein individual ones of the plurality of metal structures extend from an uppermost surface of the second interconnect layer into the dielectric layer, and wherein a portion of the dielectric layer is between individual ones of the plurality of metal structures and the substrate.

5. The IC device structure of any one of claims 1-4, wherein the one or more dielectric layers comprise metal dopants, the metal dopants comprising gallium, aluminum or boron, and wherein the density of the metal dopants is between 1e17/cm³ ₋ 1e20/cm³.

6. The IC device structure of any one of claims 1-5, wherein the one or more dielectric layers have a thickness between 0.5 microns and 10 microns.

7. The IC device structure of claim 1, wherein the first lines have a first line density per unit volume of the second interconnect layer, wherein the second lines have a second line density per unit volume of the second interconnect layer, wherein the first vias have a first via density per unit volume of the second interconnect layer, wherein the second vias have a second via density per unit volume of the second interconnect layer, wherein the first line density is greater than two times the second line density and wherein the first via density is greater than five times the second via density.

8. The IC device structure of any one of claims 1-7, further comprising one or more first via structures extending to the device layer, wherein the one or more first via structures are not in contact with one or more devices in the device layer or interconnect structures in the interconnect layer.

9. The IC device structure of claim 8, further comprising one or more second via structures extending from within a portion of the substrate to the first interconnect layer, wherein the one or more second via structures are adjacent to but not in contact with some of the plurality of devices and wherein the one or more second via structures are not in contact with the interconnect structures in the second interconnect layer or with interconnect structures in the first conductive layer.

10. The IC device structure of any one of claims 1-9, wherein the devices comprise a plurality of transistors, wherein each of the transistors comprises a channel layer material that has substantially the same composition as the substrate, and wherein the material is single crystalline silicon.

11. A system comprising:
a display (817);
an antenna (816); and
a processor (801) coupled to the antenna (816), wherein the processor (801) includes a semiconductor device structure comprising:
a first interconnect layer (102);
a second interconnect layer (104) comprising interconnect structures within a dielectric material;
a device layer (106) comprising a plurality of devices, the device layer between the first interconnect layer (102) and the second interconnect layer (104);
one or more dielectric layers (114) on the second interconnect layer (104), the dielectric layers (114) comprising one or more of metallic dopants or a plurality of metal structures, wherein the plurality of metal structures is electrically isolated from the interconnect structures but in contact with the dielectric material and wherein individual ones of the plurality of metal structures are above a region comprising at least some of the plurality of devices;
a substrate (118) over the one or more dielectric layers (114); and
a heat sink coupled with the substrate (118),
wherein the first interconnect layer (102) comprises a gridded structure (204), the gridded structure (204) comprising first lines and first vias, wherein the gridded structure (204) is electrically isolated from interconnect structures comprising second lines and second vias, and **characterized in that** the gridded structure (204) extends from above the plurality of devices towards the dielectric layer (114).

12. The system of claim 11, further comprising a battery.

13. The system of claim 12, wherein the first lines have a first line density per unit volume of the second interconnect layer, wherein the second lines have a second line density per unit volume of the second interconnect layer, wherein the first vias have a first via density per unit volume of the second interconnect layer, wherein the second vias have a second via density per unit volume of the second interconnect layer, wherein the first line density is greater than two times the second line density and wherein the first via density is greater than five times the second via density.

## Patentansprüche

1. Integrierte Schaltungs-,IC-,Vorrichtungsstruktur, umfassend:
eine erste Zwischenverbindungsschicht (102);
eine zweite Zwischenverbindungsschicht (104), die Zwischenverbindungsstrukturen innerhalb eines dielektrischen Materials umfasst;
eine Vorrichtungsschicht (106), die eine Mehrzahl von Vorrichtungen umfasst, wobei sich die Vorrichtungsschicht zwischen der ersten Zwischenverbindungsschicht (102) und der zweiten Zwischenverbindungsschicht (104) befindet;
eine oder mehrere dielektrische Schichten (114) benachbart zu der zweiten Zwischenverbindungsschicht (104) auf einer Seite gegenüber der ersten Zwischenverbindungsschicht (102), wobei die dielektrischen Schichten (114) eines oder mehrere von metallischen Dotierstoffen oder einer Mehrzahl von Metallstrukturen umfassen, wobei die metallischen Dotierstoffe oder eine Mehrzahl von Metallstrukturen elektrisch von den Zwischenverbindungsstrukturen isoliert, aber in Kontakt mit dem dielektrischen Material sind und wobei sich die metallischen Dotierstoffe oder einzelne der Mehrzahl von Metallstrukturen über mindestens einigen der Mehrzahl von Vorrichtungen befinden; und
ein Substrat (118) benachbart zu den dielektrischen Schichten (114),
wobei die erste Zwischenverbindungsschicht (102) eine Gitterstruktur (204) umfasst, wobei die Gitterstruktur (204) erste Leitungen und erste Vias umfasst, wobei die Gitterstruktur (204) elektrisch von Zwischenverbindungsstrukturen isoliert ist, die zweite Leitungen und zweite Vias umfassen, und **dadurch gekennzeichnet, dass**
die Gitterstruktur (204) sich von über der Mehrzahl von Vorrichtungen zu der einen oder den mehreren dielektrischen Schichten (114) erstreckt.

2. IC-Vorrichtungsstruktur nach Anspruch 1, wobei die eine oder die mehreren dielektrischen Schichten ferner Folgendes umfassen:
eine erste dielektrische Schicht;
eine zweite dielektrische Schicht auf der ersten dielektrischen Schicht;
eine erste Mehrzahl von Metallstrukturen innerhalb der ersten dielektrischen Schicht; und
eine zweite Mehrzahl von Metallstrukturen innerhalb der zweiten dielektrischen Schicht, wobei die zweite Mehrzahl von Metallstrukturen im Wesentlichen vertikal mit der ersten Mehrzahl von Metallstrukturen ausgerichtet ist und wobei sich die erste Mehrzahl von Metallstrukturen und die zweite Mehrzahl von Metallstrukturen zwischen der ersten Zwischenverbindungsschicht und dem Substrat erstrecken.

3. IC-Vorrichtungsstruktur nach Anspruch 2, ferner umfassend eine dritte dielektrische Schicht zwischen der Vorrichtungsschicht und der ersten Zwischenverbindungsschicht, wobei die dritte dielektrische Schicht Stickstoff und eines oder mehrere von Bor oder Aluminium, einer Verbindung, die Aluminium, Sauerstoff und Graphen-Nanoverbundstoffe umfasst, einer Verbindung von Silicium und Kohlenstoff oder Diamant umfasst, und wobei sich Zwischenverbindungen in der ersten Zwischenverbindungsschicht durch die dritte dielektrische Schicht zu der Vorrichtungsschicht erstrecken.

4. IC-Vorrichtungsstruktur nach einem der Ansprüche 1-3, wobei sich einzelne der Mehrzahl von Metallstrukturen von einer obersten Oberfläche der zweiten Zwischenverbindungsschicht in die dielektrische Schicht erstrecken und wobei sich ein Teil der dielektrischen Schicht zwischen einzelnen der Mehrzahl von Metallstrukturen und dem Substrat befindet.

5. IC-Vorrichtungsstruktur nach einem der Ansprüche 1-4, wobei die eine oder die mehreren dielektrischen Schichten Metalldotierstoffe umfassen, wobei die Metalldotierstoffe Gallium, Aluminium oder Bor umfassen und wobei die Dichte der Metalldotierstoffe 1e17/cm³-1e20/cm³ beträgt.

6. Verfahren nach einem der Ansprüche 1 bis 5, wobei die eine oder die mehreren dielektrischen Schichten eine Dicke zwischen 0,5 Mikrometern und 10 Mikrometern aufweisen.

7. IC-Vorrichtungsstruktur nach Anspruch 1, wobei die ersten Leitungen eine erste Leitungsdichte pro Volumeneinheit der zweiten Zwischenverbindungsschicht aufweisen, wobei die zweiten Leitungen eine zweite Leitungsdichte pro Volumeneinheit der zweiten Zwischenverbindungsschicht aufweisen, wobei die ersten Vias eine erste Via-Dichte pro Volumeneinheit der zweiten Zwischenverbindungsschicht aufweisen, wobei die zweiten Vias eine zweite Via-Dichte pro Volumeneinheit der zweiten Zwischenverbindungsschicht aufweisen, wobei die erste Leitungsdichte mehr als das Zweifache der zweiten Leitungsdichte beträgt und wobei die erste Via-Dichte mehr als das Fünffache der zweiten Via-Dichte beträgt.

8. IC-Vorrichtungsstruktur nach einem der Ansprüche 1-7, ferner umfassend eine oder mehrere erste Via-Strukturen, die sich zu der Vorrichtungsschicht erstrecken, wobei die eine oder die mehreren ersten Via-Strukturen weder mit einer oder mehreren Vorrichtungen in der Vorrichtungsschicht noch mit Zwischenverbindungsstrukturen in der Zwischenverbindungsschicht in Kontakt sind.

9. IC-Vorrichtungsstruktur nach Anspruch 8, ferner umfassend eine oder mehrere zweite Via-Strukturen, die sich von innerhalb eines Teils des Substrats zu der ersten Zwischenverbindungsschicht erstrecken, wobei die eine oder die mehreren zweiten Via-Strukturen benachbart zu einigen der Mehrzahl von Vorrichtungen, aber nicht in Kontakt damit sind, und wobei die eine oder die mehreren zweiten Via-Strukturen weder mit den Zwischenverbindungsstrukturen in der zweiten Zwischenverbindungsschicht noch mit Zwischenverbindungsstrukturen in der ersten leitfähigen Schicht in Kontakt sind.

10. IC-Vorrichtungsstruktur nach einem der Ansprüche 1-9, wobei die Vorrichtungen eine Mehrzahl von Transistoren umfassen, wobei jeder der Transistoren ein Kanalschichtmaterial umfasst, das im Wesentlichen die gleiche Zusammensetzung wie das Substrat aufweist, und wobei das Material einkristallines Silicium ist.

11. System, umfassend:
eine Anzeige (817);
eine Antenne (816) und
einen Prozessor (801), der mit der Antenne (816) gekoppelt ist, wobei der Prozessor (801) eine Halbleitervorrichtungsstruktur aufweist, die Folgendes umfasst:
eine erste Zwischenverbindungsschicht (102);
eine zweite Zwischenverbindungsschicht (104), die Zwischenverbindungsstrukturen innerhalb eines dielektrischen Materials umfasst;
eine Vorrichtungsschicht (106), die eine Mehrzahl von Vorrichtungen umfasst, wobei sich die Vorrichtungsschicht zwischen der ersten Zwischenverbindungsschicht (102) und der zweiten Zwischenverbindungsschicht (104) befindet;
eine oder mehrere dielektrische Schichten (114) auf der zweiten Zwischenverbindungsschicht (104), wobei die dielektrischen Schichten (114) eines oder mehrere von metallischen Dotierstoffen oder einer Mehrzahl von Metallstrukturen umfassen, wobei die Mehrzahl von Metallstrukturen elektrisch von den Zwischenverbindungsstrukturen isoliert, aber in Kontakt mit dem dielektrischen Material ist und wobei sich einzelne der Mehrzahl von Metallstrukturen über einem Gebiet befinden, das mindestens einige der Mehrzahl von Vorrichtungen umfasst;
ein Substrat (118) über der einen oder den mehreren dielektrischen Schichten (114); und
einen Kühlkörper, der mit dem Substrat (118) gekoppelt ist,
wobei die erste Zwischenverbindungsschicht (102) eine Gitterstruktur (204) umfasst, wobei die Gitterstruktur (204) erste Leitungen und erste Vias umfasst, wobei die Gitterstruktur (204) elektrisch von Zwischenverbindungsstrukturen isoliert ist, die zweite Leitungen und zweite Vias umfassen, und **dadurch gekennzeichnet, dass**
die Gitterstruktur (204) sich von über der Mehrzahl von Vorrichtungen zu der dielektrischen Schicht (114) erstreckt.

12. System nach Anspruch 11, ferner umfassend eine Batterie.

13. System nach Anspruch 12, wobei die ersten Leitungen eine erste Leitungsdichte pro Volumeneinheit der zweiten Zwischenverbindungsschicht aufweisen, wobei die zweiten Leitungen eine zweite Leitungsdichte pro Volumeneinheit der zweiten Zwischenverbindungsschicht aufweisen, wobei die ersten Vias eine erste Via-Dichte pro Volumeneinheit der zweiten Zwischenverbindungsschicht aufweisen, wobei die zweiten Vias eine zweite Via-Dichte pro Volumeneinheit der zweiten Zwischenverbindungsschicht aufweisen, wobei die erste Leitungsdichte mehr als das Zweifache der zweiten Leitungsdichte beträgt und wobei die erste Via-Dichte mehr als das Fünffache der zweiten Via-Dichte beträgt.

## Revendications

1. Structure de dispositif à circuit intégré, CI, comprenant :
une première couche d'interconnexion (102) ;
une deuxième couche d'interconnexion (104) comprenant des structures d'interconnexion à l'intérieur d'un matériau diélectrique ;
une couche de dispositif (106) comprenant une pluralité de dispositifs, la couche de dispositif se situant entre la première couche d'interconnexion (102) et la deuxième couche d'interconnexion (104) ;
une ou plusieurs couches diélectriques (114) adjacentes à la deuxième couche d'interconnexion (104) d'un côté opposé à la première couche d'interconnexion (102), les couches diélectriques (114) comprenant un ou plusieurs dopants métalliques ou une pluralité de structures métalliques, où les dopants métalliques ou une pluralité de structures métalliques sont isolés électriquement des structures d'interconnexion mais en contact avec le matériau diélectrique et où les dopants métalliques ou les structures métalliques individuelles de la pluralité de structures métalliques sont au-dessus d'au moins certains de la pluralité de dispositifs ; et
un substrat (118) adjacent aux couches diélectriques (114),
où la première couche d'interconnexion (102) comprend une structure quadrillée (204), la structure quadrillée (204) comprenant des premières lignes et des premiers vias, où la structure quadrillée (204) est isolée électriquement des structures d'interconnexion comprenant des deuxièmes lignes et des deuxièmes vias, la structure étant **caractérisée en ce que**
la structure quadrillée (204) s'étend depuis le dessus de la pluralité de dispositifs vers les une ou plusieurs couches diélectriques (114).

2. Structure de dispositif à circuit intégré, CI, selon la revendication 1, dans laquelle les une ou plusieurs couches diélectriques comprennent en outre :
une première couche diélectrique ;
une deuxième couche diélectrique sur la première couche diélectrique ;
une première pluralité de structures métalliques à l'intérieur de la première couche diélectrique ; et
une deuxième pluralité de structures métalliques à l'intérieur de la deuxième couche diélectrique, la deuxième pluralité de structures métalliques étant sensiblement alignées verticalement avec la première pluralité de structures métalliques, et où la première pluralité de structures métalliques et la deuxième pluralité de structures métalliques s'étendent entre la première couche d'interconnexion et le substrat.

3. Structure de dispositif à circuit intégré, CI, selon la revendication 2, comprenant en outre une troisième couche diélectrique entre la couche de dispositif et la première couche d'interconnexion, la troisième couche diélectrique comprenant de l'azote et un ou plusieurs éléments parmi le bore ou l'aluminium, un composé comprenant des nanocomposites d'aluminium, d'oxygène et de graphène, un composé de silicium et de carbone, ou du diamant, et où les interconnexions dans la première couche d'interconnexion s'étendent jusqu'à la couche de dispositif à travers la troisième couche diélectrique.

4. Structure de dispositif à circuit intégré, CI, selon l'une quelconque des revendications 1 à 3, dans laquelle des structures individuelles de la pluralité de structures métalliques s'étendent depuis une surface supérieure de la deuxième couche d'interconnexion jusque dans la couche diélectrique, et où une partie de la couche diélectrique est située entre des structures individuelles de la pluralité de structures métalliques et le substrat.

5. Structure de dispositif CI selon l'une quelconque des revendications 1 à 4, dans laquelle les une ou plusieurs couches diélectriques comprennent des dopants métalliques, les dopants métalliques comprenant du gallium, de l'aluminium ou du bore, et dans laquelle la densité des dopants métalliques est comprise entre 1e17/cm³ et 1e20/cm³.

6. Structure de dispositif CI selon l'une quelconque des revendications 1 à 5, dans laquelle les une ou plusieurs couches diélectriques ont une épaisseur comprise entre 0,5 micron et 10 microns.

7. Structure de dispositif CI selon la revendication 1, dans laquelle les premières lignes ont une première densité de lignes par unité de volume de la deuxième couche d'interconnexion, dans laquelle les deuxièmes lignes ont une deuxième densité de lignes par unité de volume de la deuxième couche d'interconnexion, dans laquelle les premiers vias ont une première densité de vias par unité de volume de la deuxième couche d'interconnexion, dans laquelle les deuxièmes vias ont une deuxième densité de vias par unité de volume de la deuxième couche d'interconnexion, dans laquelle la première densité de lignes est supérieure à deux fois la deuxième densité de lignes et dans laquelle la première densité de vias est supérieure à cinq fois la deuxième densité de vias.

8. Structure de dispositif CI selon l'une quelconque des revendications 1 à 7, comprenant en outre une ou plusieurs premières structures de vias s'étendant jusqu'à la couche de dispositif, où les une ou plusieurs premières structures de vias ne sont pas en contact avec un ou plusieurs dispositifs dans la couche de dispositif ou les structures d'interconnexion dans la couche d'interconnexion.

9. Structure de dispositif CI selon la revendication 8, comprenant en outre une ou plusieurs deuxièmes structures de vias s'étendant de l'intérieur d'une partie du substrat jusqu'à la première couche d'interconnexion, où les une ou plusieurs deuxièmes structures de vias sont adjacentes mais pas en contact avec certains de la pluralité de dispositifs, et où les une ou plusieurs deuxièmes structures de vias ne sont pas en contact avec les structures d'interconnexion dans la deuxième couche d'interconnexion ou avec des structures d'interconnexion dans la première couche conductrice.

10. Structure de dispositif CI selon l'une quelconque des revendications 1 à 9, dans laquelle les dispositifs comprennent une pluralité de transistors, où chacun des transistors comprend un matériau de couche de canal qui a sensiblement la même composition que le substrat, et où le matériau est du silicium monocristallin.

11. Système comprenant :
un dispositif d'affichage (817) ;
une antenne (816) ; et
un processeur (801) couplé à l'antenne (816), où le processeur (801) comprend une structure de dispositif à semi-conducteurs comprenant :
une première couche d'interconnexion (102) ;
une deuxième couche d'interconnexion (104) comprenant des structures d'interconnexion à l'intérieur d'un matériau diélectrique ;
une couche de dispositif (106) comprenant une pluralité de dispositifs, la couche de dispositif se situant entre la première couche d'interconnexion (102) et la deuxième couche d'interconnexion (104) ;
une ou plusieurs couches diélectriques (114) sur la deuxième couche d'interconnexion (104), les couches diélectriques (114) comprenant un ou plusieurs dopants métalliques ou une pluralité de structures métalliques, où la pluralité de structures métalliques sont électriquement isolées des structures d'interconnexion mais en contact avec le matériau diélectrique, et où des structures individuelles de la pluralité de structures métalliques sont au-dessus d'une région comprenant au moins certains de la pluralité de dispositifs ;
un substrat (118) sur les une ou plusieurs couches diélectriques (114) ; et
un dissipateur thermique couplé au substrat (118),
où la première couche d'interconnexion (102) comprend une structure quadrillée (204), la structure quadrillée (204) comprenant des premières lignes et des premiers vias, où la structure quadrillée (204) est isolée électriquement des structures d'interconnexion comprenant des deuxièmes lignes et des deuxièmes vias, la structure étant **caractérisée en ce que**
la structure quadrillée (204) s'étend depuis le dessus de la pluralité de dispositifs vers la couche diélectrique (114).

12. Système selon la revendication 11 comprenant en outre une batterie.

13. Système selon la revendication 12, dans lequel les premières lignes ont une première densité de lignes par unité de volume de la deuxième couche d'interconnexion, dans lequel les deuxièmes lignes ont une deuxième densité de lignes par unité de volume de la deuxième couche d'interconnexion, dans lequel les premiers vias ont une première densité de vias par unité de volume de la deuxième couche d'interconnexion, dans lequel les deuxièmes vias ont une deuxième densité de vias par unité de volume de la deuxième couche d'interconnexion, dans lequel la première densité de lignes est supérieure à deux fois la deuxième densité de lignes et dans lequel la première densité de vias est supérieure à cinq fois la deuxième densité de vias.
